# EUROPEAN PATENT SPECIFICATION

(11) **EP 2 448 154 B1**
(45) Date of publication and mention of the grant of the patent: **17.08.2016**
(21) Application number: 11186333.8
(22) Date of filing: 24.10.2011
(51) Int. Cl.: H04H 20/16, H04H 60/74, H04L 1/00, H04L 1/20, H03M 13/09

(54) **Digital audio broadcasting receiver and label information display method of the same**
Digitaler Audiorundfunkempfänger und Service-Name Anzeigeverfahren dafür
Récepteur de diffusion audio numérique et son procédé d'affichage du nom du service

(30) Priority: 26.10.2010 JP 2010239685
(43) Date of publication of application: 02.05.2012
(73) Proprietor: Alpine Electronics, Inc., Tokyo (JP)
(72) Inventor: Chiba, Masatoshi, Iwaki-City, Fukushima (JP)
(74) Representative: Klunker . Schmitt-Nilson . Hirsch

(56) References cited:
- EP-A2- 0 833 468
- EP-A2- 0 881 792
- US-A1- 2005 048 923
- US-A1- 2006 053 352

## Description

### BACKGROUND OF THE INVENTION

### 1. Field of the Invention

The present invention relates generally to digital audio broadcasting receivers and service label display methods of the same. In particular, the present invention relates to a digital audio broadcasting receiver having a function for displaying a name (i.e., a label) attached to a selected program (i.e., a service) that is being received and a label information display method of the same.

### 2. Description of the Related Art

In recent years, analog broadcasting has been being replaced by digital broadcasting that can realize output of high-quality images and high-quality audio and can realize multiplexing of various kinds of data. In Europe, digital audio broadcasting (DAB) has already been put into practical use.

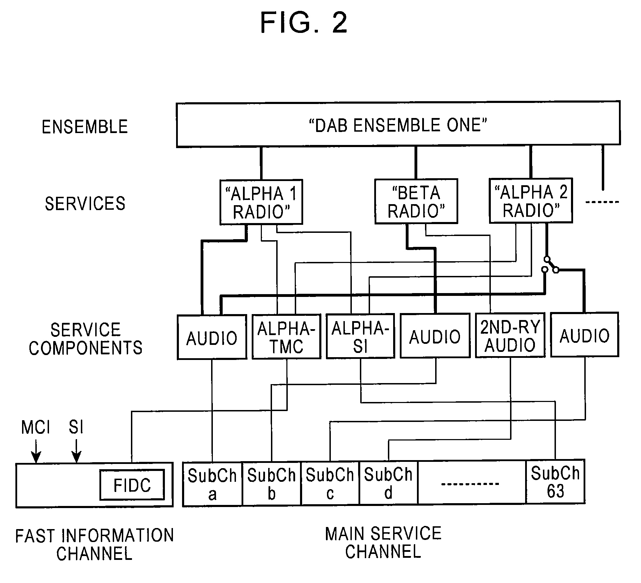

Fig. 2 illustrates an example of a DAB service structure, which is basically a three-layer hierarchical tree structure. An ensemble at a top layer is units of services transmitted over carrier radio waves having the same center frequency. One ensemble includes a plurality of services at a middle layer. Each service includes a plurality of service components at a bottom layer.

As described in detail later, in such a DAB system, label data for realizing a function for displaying a name (i.e., a label) attached to each service is multiplexed into data of various services and is transmitted from broadcasting stations. By using the label, a reception side (e.g., a DAB receiver) displays character data indicating a name of a service that is being received on a display device. Users can recognize content of the currently received service by watching this displayed character data and determine whether the service is a desired one.

As a technique relating to this function, a technique for acquiring a service label from a fast information group (FIG) of a currently received ensemble and displaying the service label is known (see, for example, Japanese Unexamined Patent Application Publication No. 2001-358673, Fig. 8).

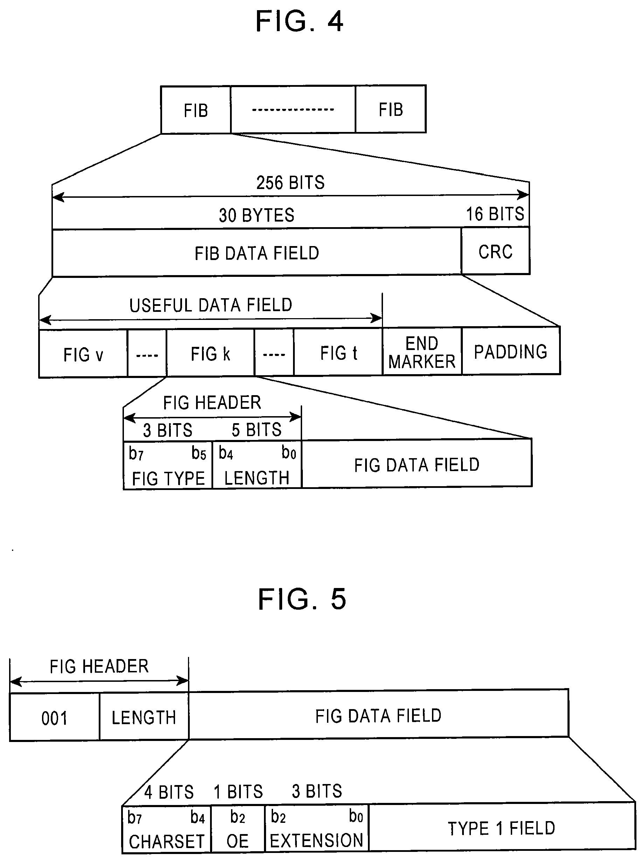

Additionally, in a DAB system, an error detection code called cyclic redundancy check (CRC) is attached to broadcast signal data and transmitted as packet data at certain cycles in order to detect whether error-free broadcast signal data is transmitted from a transmission side to a reception side. The reception side divides the packet data into "payload" and a "CRC value". The reception side calculates a CRC value of the received "payload" and then compares the calculated CRC value with the received "CRC value". The "payload" and the "CRC value" mentioned herein correspond to an "FIB data field" and "CRC", respectively, in a structure of a fast information block (FIB) illustrated in Fig. 4.

When both the received "payload" and the received "CRC value" are error-free, the compared CRC values match. Accordingly, the reception side (e.g., a DAB receiver) considers that the received data is error-free, loads the received "payload", and performs required processing. For example, the reception side acquires service label information from a fast information group (FIG) included in FIB data and displays a service name of a program on a screen of a display device.

In contrast, when one of the received "payload" and the received "CRC value" contains an error, the compared CRC values do not match. Accordingly, the reception side considers that the received data contains an error and discards the received "payload". At this time, a currently displayed service name is maintained.

When both the received "payload" and the received "CRC value" contain errors, the compared CRC values do not match generally but may accidentally match.

As described above, a DAB receiver according to the related art performs a CRC calculation regarding FIB data included in broadcast signal data transmitted from a broadcasting station and controls displaying of a service name (i.e., displaying of label information) based on a result of comparison of the calculation result with CRC data included in the FIB data.

However, when compared CRC values accidentally match because data errors occur both in received payload (i.e., an FIB data field) and a received CRC value, it is difficult with the present technique to determine whether the CRC values match because received data is error-free or the CRC values happen to match although the received data contains errors. That is, since correctness of transmitted data is determined based on the CRC calculation result alone, it is difficult to handle a case where the compared CRC values accidentally match.

Such a case where the compared CRC values accidentally match regardless of occurrence of errors is likely to happen when a reception state is poor, particularly under an environment of a weak electric field. As a result, a wrong service name (i.e., label information) may be displayed on a display device.

Additionally, when the wrong service name is displayed, the display data is not updated until the CRC values match next time. Thus, the wrong service name is kept being displayed for that period, causing inconvenience for users.

EP 0 833 468 A2 discloses a DAB radio that receives audio data, service label data as string data, and data for judging abridgement of each character of the service data. Each service label can be displayed properly on a display unit. An abridged representation judging unit judges whether each service label is displayed in an abridged representation or in a full representation, in accordance with the conditions of a maximum display size of the display unit, a user selection of representations, or the like. If it is judged that the service label is displayed in the abridged representation, a representation control unit forms a service label in the abridged representation in accordance with abridgement judging data to thereby display an abridged service label on the display unit.

US 2005 048 923 A1 discloses a system and a method for bad frame indication of a speech frame includes estimating a signal-to-noise ratio (SNR) and checking a cyclic redundancy code (CRC) value of the speech frame. When the speech frame fails CRC error detection or the SNR is below a pre-specified value, a bad frame indication (BFI) flag is set. When the speech frame passes CRC error detection and the SNR is above the pre-specified value, a receive signal quality metric of the speech frame is checked against a high threshold and, if need be, a low threshold. The BFI flag and the receive signal quality metric for the previous speech frame is checked when the current receive signal quality metric is between the high and low thresholds. The BFI flag is set according to the value of the SNR, the CRC value, the current and previous receive signal quality metrics, and the previous BFI flag.

### SUMMARY OF THE INVENTION

The present invention has been made in view of such problems in the related art and an object thereof is to provide digital audio broadcasting receivers capable of effectively handling a CRC detection error even when a reception state worsens and of decreasing frequency in displaying wrong label information and to provide label information display methods of the same.

The problems in the related art are solved according to the claims.

In the following, the word embodiment is to be understood as example.

In accordance with one embodiment of the present invention, a digital audio broadcasting receiver is provided that includes: a display unit; a tuner for selecting a broadcast wave signal of a broadcasting station, in accordance with an instruction, from a transmitted digital broadcasting radio wave into which a plurality of broadcast programs are multiplexed; and a control unit for performing CRC calculations regarding a plurality of pieces of specific data included in the selected broadcast wave signal and controlling the display unit based on comparison of the calculation results with CRC data included in the plurality of pieces of specific data so that label information regarding a currently received program is displayed. When a reception state of the selected broadcast wave signal falls below a given level, the control unit stops the CRC calculation regarding a piece of specific data loaded at that time and controls the display unit so that the currently displayed label information is maintained.

The digital audio broadcasting receiver according to this embodiment may stop acquiring the label information from the pieces of specific data once the CRC calculation is stopped.

In according with another embodiment of the present invention, a digital audio broadcasting receiver is provided that includes: a display unit; a tuner for selecting a broadcast wave signal of a broadcasting station, in accordance with an instruction, from a transmitted digital broadcasting radio wave into which a plurality of broadcast programs are multiplexed; and a control unit for performing CRC calculations regarding a plurality of pieces of specific data included in the selected broadcast wave signal and controlling the display unit based on comparison of the calculation results with CRC data included in the plurality of pieces of specific data so that label information regarding a currently received program is displayed. When a reception state of the selected broadcast wave signal falls below a given level, the control unit loads a plurality of pieces of specific data and performs the CRC calculation regarding each piece of specific data. When the calculation results indicate that a CRC error occurs at a certain probability or higher, the control unit controls the display unit so that the currently displayed label information is maintained.

In accordance with still another embodiment of the present invention, a digital audio broadcasting receiver is provided that includes: a display unit; a tuner for selecting a broadcast wave signal of a broadcasting station, in accordance with an instruction, from a transmitted digital broadcasting radio wave into which a plurality of broadcast programs are multiplexed; and a control unit for performing CRC calculations regarding a plurality of pieces of specific data included in the selected broadcast wave signal and controlling the display unit based on comparison of the calculation results with CRC data included in the plurality of pieces of specific data so that label information regarding a currently received program is displayed. When a reception state of the selected broadcast wave signal falls below a given level, the control unit sequentially loads a plurality of pieces of specific data and performs the CRC calculation regarding each piece of specific data. When the calculation results indicate that the CRC values successively match a plurality of times, the control unit controls the display unit so that the displayed label information is updated based on label information included in a last piece of the successive pieces of specific data.

In accordance with a further embodiment of the present invention, a label information display method is provided that is carried out by the digital audio broadcasting receiver according to each of the aforementioned embodiments.

With a digital audio broadcasting receiver according to one embodiment of the present invention and a label information display method of the same, a CRC calculation is performed regarding each of a plurality of pieces of specific data (e.g., each FIB in a DAB signal) included in a broadcast wave signal selected in accordance with an instruction from a transmitted radio wave of digital broadcasting (e.g., DAB) into which a plurality of broadcast programs are multiplexed. Based on comparison of the calculation result with CRC data included in the piece of specific data, when a reception state of the currently selected broadcast wave signal falls below a given level with label information (i.e., a service name) regarding a currently received program being displayed on a display unit, control is performed so that the CRC calculation regarding a piece of specific data (e.g., an FIB) loaded at that time is stopped and the currently displayed label information is maintained.

Since correctness of transmitted data is determined based not only on a CRC calculation result but also on the reception state unlike the present technique, CRC detection errors can be effectively handled even when the reception state worsens (particularly, at the time of a weak electric field). In this way, frequency in displaying wrong label information (i.e., a service name) can be decreased.

Since the CRC calculation is performed in consideration of the reception state similarly in digital audio broadcasting receivers according to other embodiments of the present invention and label information display methods of the same, advantages similar to the foregoing ones can be provided. Furthermore, additional advantages can be provided, which will be described in the description of the preferred embodiments.

### BRIEF DESCRIPTION OF THE DRAWINGS

Fig. 1 is a block diagram illustrating a configuration of a digital audio broadcasting (DAB) receiver according to an embodiment of the present invention;
Fig. 2 is a diagram illustrating an example of a DAB service structure;
Fig. 3 is a diagram illustrating a structure of a DAB transmission frame;
Fig. 4 is a diagram illustrating a structure of a fast information block (FIB) in DAB;
Fig. 5 is a diagram illustrating a structure of a fast information group (FIG) data field when a FIG type is equal to 1 in the FIB illustrated in Fig. 4;
Fig. 6 is a flowchart illustrating an example of processing for displaying a service name, performed in the DAB receiver illustrated in Fig. 1, according to a first embodiment;
Fig. 7 is a diagram for additionally describing processing content of Fig. 6;
Fig. 8 is a flowchart illustrating an example of processing for displaying a service name, performed in the DAB receiver illustrated in Fig. 1, according to a second embodiment;
Fig. 9 is a diagram for additionally describing processing content of Fig. 8;
Fig. 10 is a flowchart illustrating an example of processing for displaying a service name, performed in the DAB receiver illustrated in Fig. 1, according to a third embodiment; and
Fig. 11 is a diagram for additionally describing processing content of Fig. 10.

### DESCRIPTION OF THE PREFERRED EMBODIMENTS

Embodiments of the present invention will be described below with reference to the attached drawings. In an embodiment, a description will be given for an example of a DAB receiver serving as a digital audio broadcasting receiver.

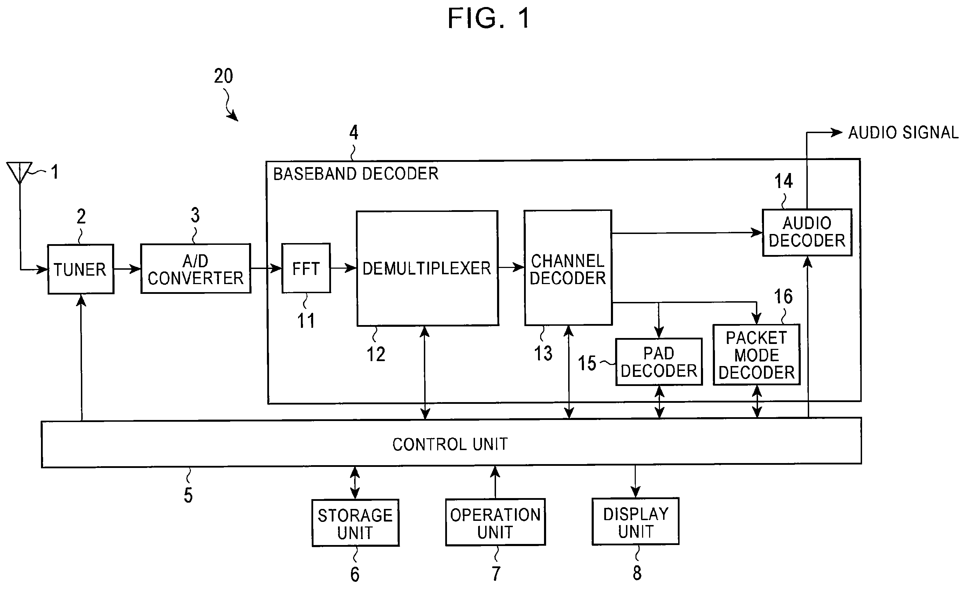

Fig. 1 is a block diagram illustrating a configuration of a digital audio broadcasting (DAB) receiver 20 according to an embodiment of the present invention. As illustrated in Fig. 1, the DAB receiver 20 includes an antenna 1, a tuner 2, an analog-to-digital (A/D) converter 3, a baseband decoder 4, a control unit 5, a storage unit 6, an operation unit 7, and a display unit 8. The antenna 1 receives a digital broadcast radio wave in the orthogonal frequency division multiplexing (OFDM) format.

The tuner 2 selectively extracts a broadcast wave signal having a reception frequency matching a desired channel from the radio wave of digital broadcasting, such as DAB and digital multimedia broadcasting (DMB), received through the antenna 1. The tuner 2 down-converts the extracted signal to a baseband and outputs the signal. The A/D converter 3 converts the down-converted analog baseband signal into a digital signal.

The baseband decoder 4 includes a fast Fourier transform (FFT) unit 11, a demultiplexer 12, a channel decoder 13, an audio decoder 14, a program associated data (PAD) decoder 15, and a packet mode decoder 16. The FFT unit 11 performs fast Fourier transform on the baseband signal digitalized by the A/D converter 3 to acquire reception symbols. The demultiplexer 12 demultiplexes digital signals that are multiplexed (OFDM demodulation).

The channel decoder 13 extracts a given music channel and a given data channel from a DAB transmission frame constituted by reception symbols resulting from the OFDM demodulation. Additionally, the channel decoder 13 divides the transmission frame into a fast information channel (FIC) and a main service channel (MSC) including a plurality of music channels and a plurality of data channels. The channel decoder 13 also performs processing, such as deinterleave, Viterbi decoding, and energy dispersal descrambling, on a channel selected from the MSC by a user. Similarly, the channel decoder 13 performs processing, such as Viterbi decoding and energy dispersal descrambling, on the FIC.

Among the digital signals decoded in the channel decoder 13, audio data included in the MSC is sent to the audio decoder 14, whereas non-audio data included the FIC, i.e., FIG data (described later) such as a program type, is sent to the control unit 5.

Among the audio data output from the channel decoder 13, the audio decoder 14 decodes audio data of a sub channel instructed by the control unit 5. The decoded signal (i.e., the audio data) is output as sound through a digital-to-analog (D/A) converter, an amplifier, and a speaker that are not illustrated. The PAD decoder 15 decodes PAD and multimedia object transfer (MOT) data attached to a service and reconfigures data. The packet mode decoder 16 decodes a service-constituting packet extracted by the channel decoder 13 and reconfigures data.

The control unit 5, such as a microcomputer, works in cooperation with other functional blocks (e.g., the tuner 2, the baseband decoder 4, the storage unit 6, the operation unit 7, and the display unit 8) to control various kinds of processing regarding reception of digital audio broadcasting.

Upon receiving a channel setting control signal in response to an operation of the operation unit 7 by a user, the control unit 5 determines a channel to be received by the tuner 2 and sets a reception frequency matching this channel in the tuner 2. More specifically, the control unit 5 specifies one ensemble from a plurality of ensembles (each ensemble is transmitted over a radio broadcasting wave modulated based on differential quadrature phase shift keying OFDM (DQPSK-OFDM) and a bandwidth of one ensample is approximately 1.5 MHz) and sends information on the specified ensemble to the tuner 2. Upon receiving this specification information, the tuner 2 extracts a signal of the specified ensemble (i.e., a selected broadcast wave signal), down-converts the extracted signal to a baseband, and outputs the baseband signal.

The control unit 5 also works in cooperation with the PAD decoder 15 to reconfigure an MOT object, to analyze a fast information group (FIG) partially constituting a fast information block (FIB) included in the FIC divided by the channel decoder 13 and determine whether there is a broadcasting station that broadcasts the same content, and to control displaying of label information (i.e., a service name) as described later.

The storage unit 6, such as a hard disk and a semiconductor memory, temporarily stores program information of a currently received broadcasting program and control information, such as an FIG contained in an FIC, through the control unit 5.

The operation unit 7 includes various operation keys and buttons needed by users to operate the DAB receiver 20. This operation unit 7 gives an input instruction for selecting a desired broadcasting station to the tuner 2 through the control unit 5. Also, this operation unit 7 gives an input instruction for displaying label information (i.e., a service name) to the display unit 8 through the control unit 5.

The display unit 8, such as a liquid crystal display (LCD), displays data decoded by the PAD decoder 15 or the packet mode decoder 16. Additionally, the display unit 8 displays a menu screen allowing users to input various instructions. Further, as information relating to the present invention, the display unit 8 displays character data (i.e., a label) indicating a name of a selected program (i.e., a service) that is being received. When the display unit 8 includes a touch panel, this display unit 8 functions as the operation unit 7.

In the DAB receiver 20 configured in this manner, the control unit 5 works in cooperation with other functional blocks (such as the channel decoder 13, the storage unit 6, and the display unit 8) connected thereto to control displaying of label information (i.e., a service name) once a reception state worsens while the DAB receiver 20 is receiving a program (i.e., a service) of a broadcasting station selected by a user.

Processing for displaying the label information (i.e., the service name) performed by the DAB receiver 20 according to this embodiment will be described below with reference to Figs. 2 to 11.

Fig. 2 illustrates an example of a DAB service structure, which is an excerpt from the DAB standard (EN300401). As illustrated in Fig. 2, the DAB service structure is basically a three-layer hierarchical tree structure. An ensemble at a top layer is units of services transmitted over carrier radio waves having the same center frequency. One ensemble includes a plurality of services serving as a middle layer. Each service includes a plurality of service components serving as a bottom layer.

An ensemble whose ensemble label (i.e., an ensemble name) is "DAB ensemble one" includes a plurality of services (e.g., six services) whose service labels are "alpha 1 radio", "beta radio", "alpha 2 radio", and so forth. A user receives a service selected from these services with the DAB receiver 20.

The alpha 1 radio has one primary service component and two secondary service components. The primary service component is audio, whereas the secondary service components are a traffic message channel (TMC) and service information (SI). The audio component and the service information are transmitted over different sub channels (SubCh) in an MSC. The TMC is transmitted over a fast information data channel (FIDC) in an FIC. The beta radio has two service components, both are audio and are transmitted over sub channels of the MSC. The alpha 2 radio includes a TMC and SI that are the same as those of the alpha 1 radio. Depending on switching, audio may be the same as that of the alpha 1 radio.

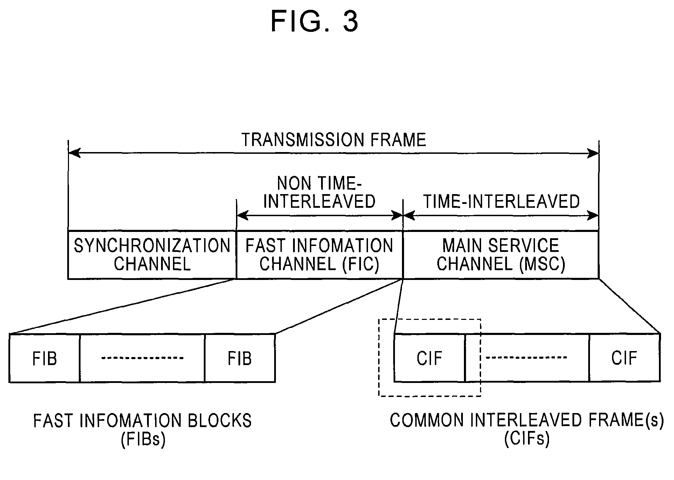

Fig. 3 illustrates a structure of a DAB transmission frame. As illustrated in Fig. 3, the transmission frame includes, sequentially from the top, a synchronization channel, an FIC, and an MSC. The synchronization channel is for identifying a frame and is used for basic demodulator functions, such as transmission frame synchronization, automatic frequency control, channel state estimation, and transmitter identification.

The FIC allows a receiver to rapidly access necessary information and includes various kinds of control information needed for selecting a program (i.e., a service). As illustrated in Fig. 3, the FIC includes a plurality of FIBs. The MSC is used for carrying video, audio, and data service components. As illustrated in Fig. 3, the MSC includes a plurality of common interleaved frames (CIFs).

In each CIF, a plurality of music sub channels and a plurality of general data sub channels are multiplexed. One sub channel corresponds to one program. Additionally, in the DAB system, specifications of transmission modes 1 to 4 are defined. Duration of one transmission frame and the numbers of FIBs and CIFs in one transmission frame differ for each transmission mode. For example, in a mode 1, the duration of one transmission frame is 96 ms and the numbers of the FIBs and CIFs in one transmission frame are 12 and 4, respectively.

Fig. 4 illustrates a structure of an FIB in DAB. One FIB contains 256 bits and includes an FIB data field occupying 30 bytes followed by a cyclic redundancy check word (CRC) occupying 16 bits. The FIB data field includes, sequentially from the top, a plurality of FIGs, one end marker, and one padding. This padding is a field for storing 0 that is filled in extra bits to make the FIB data field fit into units of bytes. The FIG part constitute a useful data field. Each FIG includes, sequentially from the top, an FIG type, length (representing bit-length of a following FIG data field), and an FIG data field. The FIG type and the length constitute an FIG header.

Fig. 5 illustrates a structure of the FIG data field when the FIG type in the FIB illustrated in Fig. 4 is equal to 1 ("001" in 3-bit binary representation). This FIG data field includes, sequentially from the top, a character set (charaset), other ensemble (OE), extension, and a type 1 field. A 4-bit code of the charaset identifies a character set to limit character information included in the FIG type 1 field. The OE identifies whether this information is regarding this ensemble or another ensemble. The extension represents an extension number in the type 1 field. As described later, the type 1 field includes label information (i.e., data indicating a name attached to a service) and so forth.

For example, the FIG type 1 field for the extension 0 (also represented as "FIG1/0") contains data associating an ID identifying an ensemble (i.e., an ensemble ID) and a label thereof (i.e., an ensemble label). An FIG1/1 contains data associating an ID identifying a service (i.e., a service ID) and a label thereof (i.e., a service label). An FIG1/4 contains data associating an ID identifying a service component (i.e., a service component ID) and a label thereof (i.e., a service component label). Additionally, in a DAB signal, information of a list of all services and all service components belonging to the ensemble is transmitted in an FIG0/2 for each ensemble currently broadcasted.

There are various FIG types (eight types in total, i.e., FIG type 0-7) other then the aforementioned FIG types. Please refer to the DAB standard (EN300401) for details thereof.

Processing for displaying a service name (i.e., label information) performed in the DAB receiver 20 (Fig. 1) will be described below for each embodiment.

### First Embodiment

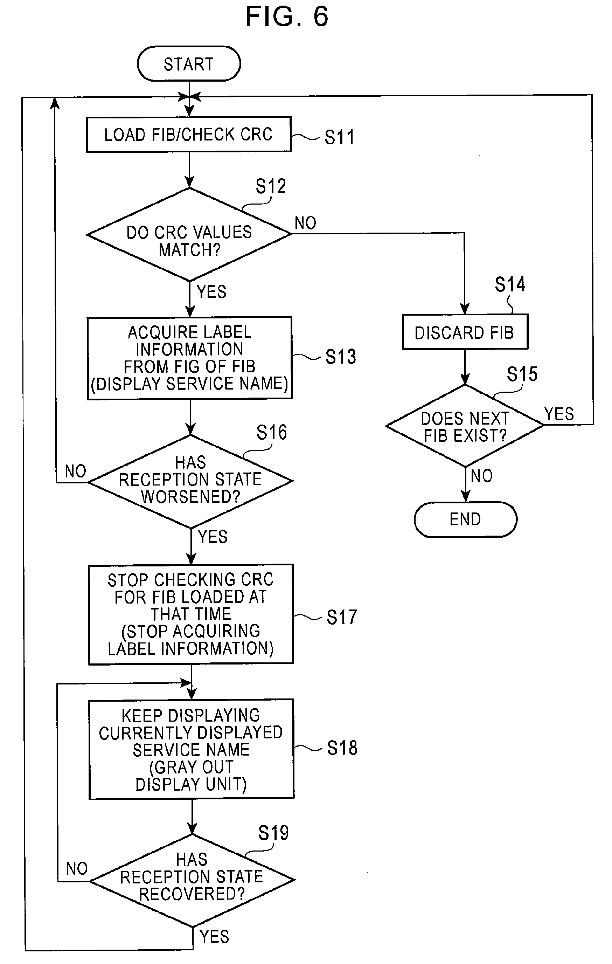

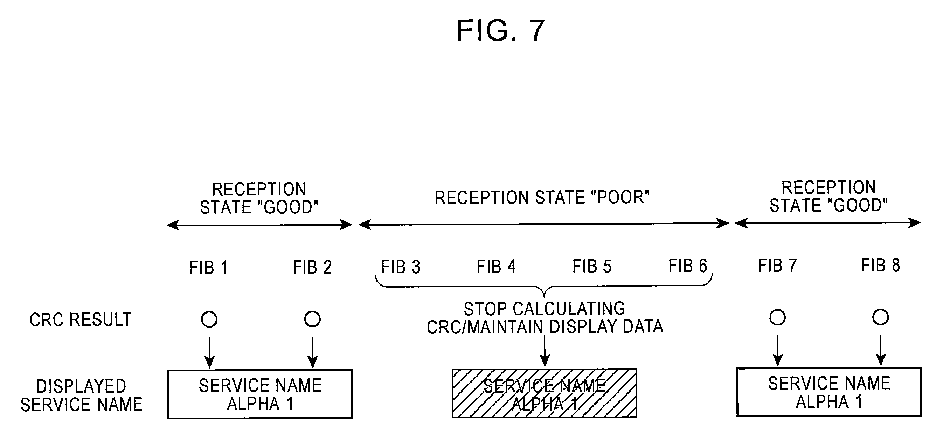

Fig. 6 is a flowchart illustrating an example of processing for displaying a service name, according to a first embodiment, performed in a DAB receiver 20. Fig. 7 is a diagram for additionally describing processing content thereof.

First, it is assumed that a program (i.e., a service) from a broadcasting station selected by a user is currently being received and a reception state thereof is good in an initial state. In this state, a control unit 5 stores data of an ID of a selected service component and a label thereof, an ID of a service that the service component belongs to and a label thereof, and an ID of an ensemble that the service belongs to and a label thereof in a storage unit 6 with reference to information of an "FIG0/2" extracted from a received signal. It is also assumed that a "service", i.e., a middle layer, is selected as a label display layer through an operation unit 7 based on a user instruction.

In such a state, in first step S11 (Fig. 6), the control unit 5 loads an FIB (e.g., an FIB 1 in the example in Fig. 7) and performs a CRC check. The CRC check is performed by dividing the loaded FIB data into payload and a CRC value (corresponding to an "FIB data field" and "CRC" in Fig. 4, respectively), performing a CRC calculation of the received payload, and comparing the calculation result (i.e., a CRC value) with the received CRC value.

In next step S12, based on the CRC check result, the control unit 5 determines whether both CRC values match (YES) or not (NO). If the determination result indicates "YES", the process proceeds to step S13. If the determination result indicates "NO", the process proceeds to step S14.

In step S14, the control unit 5 determines that received data contains an error because the CRC values do not match and discards the FIB (i.e., the payload part).

Further, in step S15, the control unit 5 determines whether an FIB following the discarded FIB (e.g., an FIB 2 in the example in Fig. 7) exists (YES) or not (NO). If the determination result indicates "YES", the process returns to step S11 and the aforementioned processing is repeated. If the determination result indicates "NO", this processing flow "ends".

In contrast, in step S13, the control unit 5 determines that the received data is error-free because the CRC values match. The control unit 5 acquires label information (i.e., data indicating a service name) from an FIG of the FIB. The control unit 5 then displays the service name on a screen of a display unit 8. In an example in Fig. 7, "ALPHA 1" is displayed as the service name.

In step S16, the control unit 5 determines whether a reception state of the currently received broadcast wave signal has worsened (YES) or not (NO). If the determination result indicates "YES", the process proceeds to step S17. If the determination result indicates "NO", the process returns to step S11 and the aforementioned processing is repeated.

The reception state can be detected by acquiring information, such as an electric field intensity of a received signal and a bit error rate (BER), from the channel decoder 13, for example. Based on detection of this reception state, when reception strength falls below a certain threshold level or when the BER (or an error correction count) rises above a certain threshold, the control unit 5 determines that the reception state has worsened.

In step S17, the control unit 5 stops the CRC check (such as a CRC calculation) regarding the FIB (e.g., an FIB 3 in the example in Fig. 7) loaded when it is determined that the reception state has worsened. The control unit 5 also stops acquiring the label information from an FIG in the FIB.

In step S18, the control unit 5 controls the display unit 8 so that the currently displayed service name (i.e., "ALPHA 1" in the example in Fig. 7) is maintained and part displaying the service name is grayed out.

In step S19, by utilizing the reception-state detection method performed in step S16, the control unit 5 determines whether the reception state has recovered to a level equal to the predetermined threshold level or higher (or the predetermined threshold or lower) (YES) or not (NO). If the determination result indicates "YES", the process returns to step S11 and the aforementioned processing is repeated. If the determination result indicates "NO", the process returns to step S18 and the display part is kept being grayed out.

As described above, in accordance with the processing for displaying the service name, according to the first embodiment, performed in the DAB receiver 20, a CRC calculation is performed for a plurality of FIBs (Fig. 4) included in a selected broadcast wave signal during reception of a program (i.e., a service) of a broadcasting station selected by a user. Based on comparison of the calculation result with CRC data included in an FIB, a service name of the program is displayed on the display unit 8. In such a state (Fig. 7), once a reception state has worsened, the CRC calculation is stopped for an FIB loaded at that time (acquisition of the label information from an FIG included in the FIB is also stopped). Additionally, the currently displayed service name (e.g., "ALPHA 1" in Fig. 7) is maintained and the display part is "grayed out".

As described above, in accordance with the first embodiment, since correctness of transmitted data is determined based not only on the CRC calculation result but also on the reception state unlike the present technique, a CRC detection error can be effectively handled even when the reception state worsens (particularly, at the time of a weak electric field). In this way, frequency in displaying a wrong service name can be decreased.

### Second Embodiment

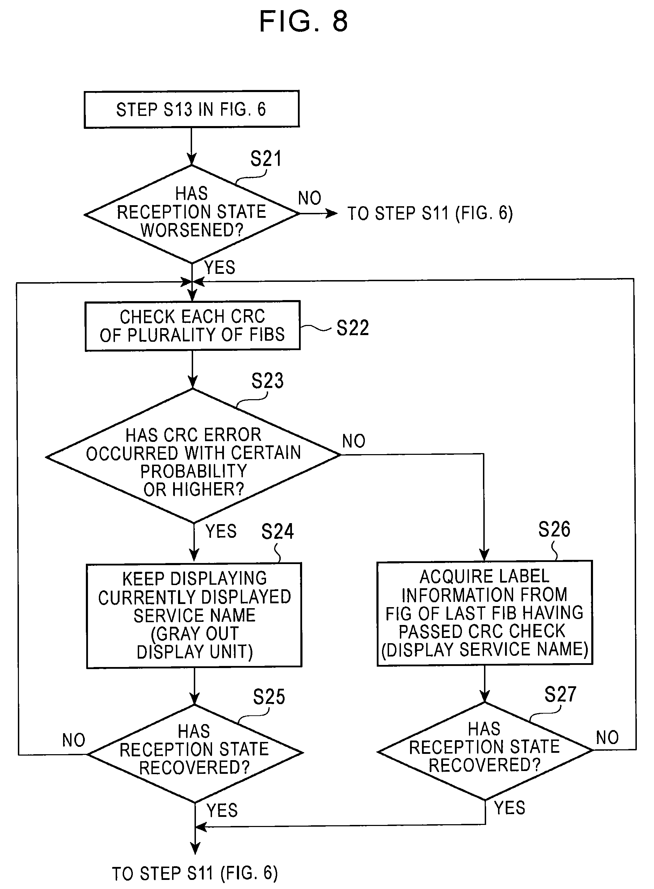

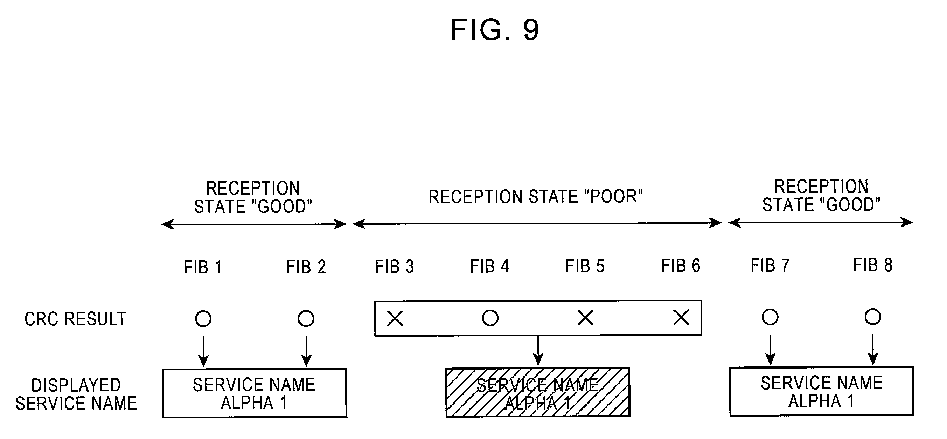

Fig. 8 is a flowchart illustrating an example of processing for displaying a service name, according to a second embodiment, performed by a DAB receiver 20. Fig. 9 is a diagram for additionally describing processing content thereof.

It is assumed that the same initial state as that in the first embodiment (Fig. 6) is used also in the second embodiment. It is also assumed that processing steps similar to steps S11-S15 are performed in this initial state.

In such a circumstance, in first step S21 (Fig. 8), a control unit 5 determines whether a reception state of a currently received broadcast wave signal has worsened (YES) or not (NO) in a way similar to the processing performed in step S16. If the determination result indicates "YES", the process proceeds to step S22. If the determination result indicates "NO", the process returns to step S11 (Fig. 6) and the aforementioned processing is repeated.

In next step S22 (when the reception state has worsened), the control unit 5 loads a plurality of FIBs (e.g., four FIBs of FIB 3 to FIB 6 in an example illustrated in Fig. 9) and performs a CRC check on each FIB. A method of the CRC check is similar to that performed in step S11.

Here, timing of loading each FIB is set to be a multiple of a transmission cycle of a broadcast wave signal transmitted from a broadcasting station. Please refer to "DAB: Guidelines and rules for implementation and operation; Part 1: System outline" published by European Telecommunications Standards Institute for details of the transmission cycle.

The loading timing may be set uniformly for all FIGs included in an FIB or may be set individually for each FIG. Alternatively, a plurality of FIGs are put into a group in accordance with the transmission cycle (importance of the FIG data (necessity of rapid access) differs for each FIG depending on an FIG type) and the loading timing may be set for each group.

In next step S23, the control unit 5 determines whether a CRC error has occurred at a predetermined probability or higher in the plurality of checked CRC values (YES) or not (NO). If the determination result indicates "YES", the process proceeds to step S24. If the determination result indicates "NO", the process proceeds to step S26. In the example illustrated in Fig. 9, the CRC error (indicated by "x") has occurred in three FIBs (i.e., FIB 3, FIB 5, and FIB 6) out of four FIBs. That is, mismatch of the CRC values occurs at a probability of 75%.

In step S24, the control unit 5 determines that an error has occurred in received data based on the CRC errors that have occurred at the predetermined probability or higher. The control unit 5 controls a display unit 8 in a way similar to the processing performed in step S18 (Fig. 6) so that a currently displayed service name (i.e., "ALPHA 1" in the example illustrated in Fig. 9) is maintained and part displaying the service name is grayed out.

In next step S25, the control unit 5 performs processing similar to that performed in step S19 (Fig. 6) to determine whether the reception state has recovered (YES) or not (NO). If the determination result indicates "YES", the process returns to step S11 (Fig. 6) and the aforementioned processing is repeated. If the determination result indicates "NO", the process returns to step S22 and the aforementioned processing is repeated.

In contrast, in step S26, the control unit 5 determines that an error has not occurred in the received data based on the CRC error that occurs at a probability lower than the predetermined probability. The control unit 5 acquires label information (i.e., data indicating a service name) from an FIG of a last FIB having passed the CRC check. The control unit 5 then displays the service name on a screen of the display unit 8. For example, in the example of the CRC result illustrated in Fig. 9, the control unit 5 updates the displayed service name based on label information acquired from an FIG of the FIB 4 that has passed the CRC check (indicated by "O") last out of the FIBs 3 to 6.

In step S27, the control unit 5 performs processing similar to that performed in step S25 to determine whether the reception state has recovered (YES) or not (NO). If the determination result indicates "YES", the process returns to step S11 (Fig. 6) and the aforementioned processing is repeated. If the determination result indicates "NO", the process returns to step S22 and the aforementioned processing is repeated.

As described above, with the processing for displaying the service name, according to the second embodiment, performed by the DAB receiver 20, advantages similar to those described above can be provided since CRC calculations are performed in consideration of the reception state as in the above-described first embodiment.

In the above-described first embodiment, the determination errors are decreased in consideration of the reception state. However, a decrease in apparent operation speed is expected since an amount of discarded data that is considered as the determination error increases. In contrast, since the CRC calculations (acquisition of the label information) are not stopped in the second embodiment, the decrease in the operation speed can be suppressed compared to the first embodiment.

Furthermore, in the second embodiment, when the CRC error occurs at a probability lower than the predetermined probability in a plurality of FIBs loaded after the reception state has worsened (i.e., step S26 in Fig. 8), the control unit 5 determines that the error has not occurred in the received data. The control unit 5 updates display data based on the label information acquired from an FIG in a last FIB having passed the CRC check. With this configuration, inconvenience seen in the present technique (i.e., a problem that a wrong service name is kept being displayed during a period since the display data is not updated until CRC values match next time after the wrong service name is displayed) can be overcome.

### Third Embodiment

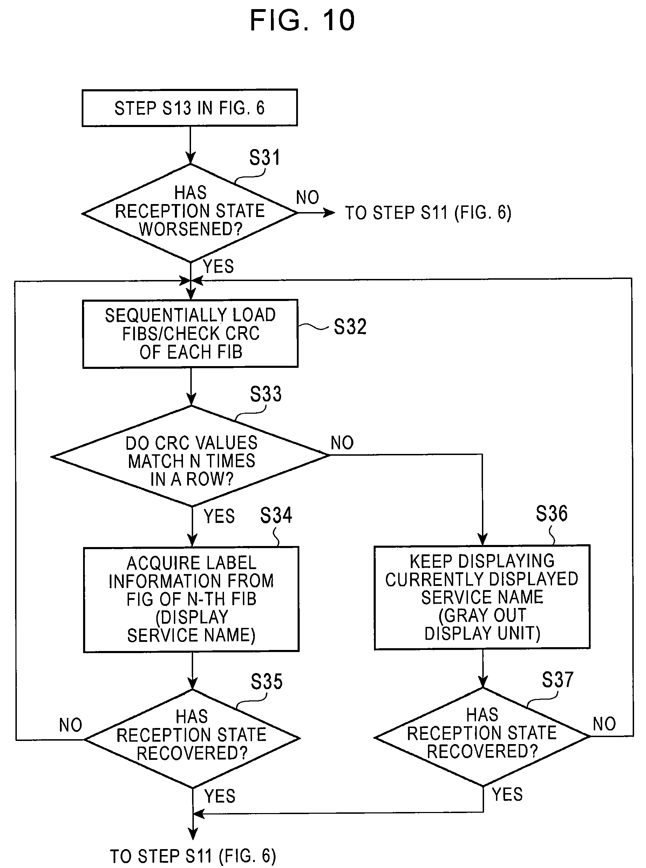

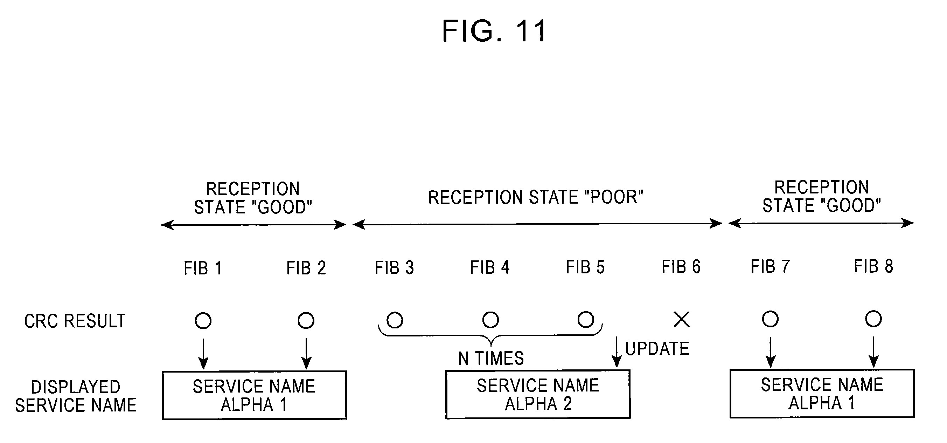

Fig. 10 is a flowchart illustrating an example of processing for displaying a service name, according to a third embodiment, performed by a DAB receiver 20. Fig. 11 is a diagram for additionally describing processing content thereof.

It is assumed that the same initial state as that of the first embodiment (Fig. 6) is used also in the third embodiment. It is also assumed that processing steps similar to steps S11 to S15 are performed in this initial state.

In such a circumstance, in first step S31 (Fig. 10), a control unit 5 performs processing similar to that performed in step S16 to determine whether a reception state of a currently received broadcast wave signal has worsened (YES) or not (NO). If the determination result indicates "YES", the process proceeds to step S32. If the determination result indicates "NO", the process returns to step S11 (Fig. 6) and the aforementioned processing is repeated.

In next step S32 (when the reception state has worsened), the control unit 5 sequentially loads FIBs (e.g., FIBs 3, 4, 5, ... in an example illustrated in Fig. 11) and performs a CRC check of each FIB. A method of the CRC check is similar to that performed in step S11. Additionally, setting of timing of loading the FIBs is also similar to the method performed in step S22 (Fig. 8).

In next step S33, the control unit 5 determines whether CRC values match N times in a row from the first FIB in process of checking the CRC values (YES) or not (NO). If the determination result indicates "YES", the process proceeds to STEP S34. If the determination result indicates "NO", the process proceeds to step S36. In the example illustrated in Fig. 11, the CRC values match (indicated by O) regarding data of three successive FIBs (i.e., FIBs 3 to 5).

In step S34, the control unit 5 determines that an error has not occurred in received data since the CRC values match N times in a row. The control unit 5 acquires label information (i.e., data indicating a service name) from an FIG of an N-th FIB (i.e., a last FIB whose CRC values match). The control unit 5 then displays the service name on a screen of a display unit 8. In the example illustrated in Fig. 11, display data is updated based on label information acquired from an FIG of the FIB 5 whose CRC values match last in N successive times and "ALPHA 2" is displayed as a service name.

In next step S35, the control unit 5 performs processing similar to that performed in step S19 (Fig. 6) to determine whether the reception state has recovered (YES) or not (NO). If the determination result indicates "YES", the process returns to step S11 (Fig. 6) and the aforementioned processing is repeated. If the determination result indicates "NO", the process returns step S32 and the aforementioned processing is repeated.

In contrast, in step S36, the control unit 5 determines that errors have occurred in the received data because the CRC values do not match N times in a row. The control unit 5 performs processing similar to that performed in step S18 (Fig. 6) and controls the display unit 8 so that a currently displayed service name (e.g., "ALPHA 1" having been displayed before the reception state has worsened in the example illustrated in Fig. 11) is maintained and part displaying the service name is grayed out.

Further, in step S37, the control unit 5 performs processing similar to that performed in step S35 to determine whether the reception state has recovered (YES) or not (NO). If the determination result indicates "YES", the process returns to step S11 (Fig. 6) and the aforementioned processing is repeated. If the determination result indicates "NO", the process returns to step S32 and the aforementioned processing is repeated.

As described above, with the processing for displaying the service name, according to the third embodiment, performed by the DAB receiver 20, advantages similar to those described above can be provided since CRC calculations are performed in consideration of the reception state as in the above-described first and second embodiments.

Furthermore, in the third embodiment, when the CRC values match a plurality of times in a row regarding FIBs sequentially loaded after the reception state has worsened (Fig. 11), the control unit 5 determines that the error has not occurred in the received data. The control unit 5 updates the display data based on the label information acquired from an FIG of the last of the successive FIBs. With this configuration, inconvenience seen in the present technique (i.e., a problem that a wrong service name is kept being displayed during a period since the display data is not updated until CRC results match next time after the wrong service name is displayed) can be overcome.

## Claims

1. A digital audio broadcasting receiver (20) comprising:
display means (8);
a tuner (2) for selecting a broadcast wave signal of a broadcasting station in accordance with an instruction, the broadcast wave signal being selected from a transmitted digital broadcasting radio wave into which a plurality of broadcast programs are multiplexed; and
control means (5) configured for:
detecting a reception state of the selected broadcast wave signal by acquiring an electric filed intensity of a received signal or/and a bit error rate BER; and for
performing CRC calculations on a fast information block FIB included in the selected broadcast wave signal, for controlling the display means (8) based on comparison of the calculation results with CRC data included in the fast information block FIB, and when the reception state of the selected broadcast wave signal falls below a given level:
loading a plurality of fast information blocks FIBs and performing the CRC calculation on each FIB;
controlling the display means (8) so that currently displayed label information is maintained, when the calculation results indicate that the CRC values do not successively match at least three times; and
controlling the display means (8) so that displayed label information is updated based on label information included in the fast information block FIB whose CRC values match last, when the calculation results indicate that the CRC values successively match at least three times.

2. The digital audio broadcasting receiver (20) according to Claim 1, wherein the control means (5) is configured to control the display means (8) so that the currently displayed label information is maintained with part displaying the label information being grayed out.

3. The digital audio broadcasting receiver (20) according to any one of Claims 1 or 2,
wherein the digital broadcasting includes digital audio broadcasting, and wherein the fast information block FIB is included in a fast information channel of a digital audio broadcasting signal.

4. A label information display method carried out by a digital audio broadcasting receiver (20) having a function for performing CRC calculations on a fast information block FIB included in a broadcast wave signal and controlling display means (8) based on comparison of the calculation results with CRC data included in the fast information block FIB, the broadcast wave signal being selected from a transmitted digital broadcasting radio wave in accordance with an instruction, a plurality of broadcast programs being multiplexed into the digital broadcasting radio wave,
the label information display method of the digital audio broadcasting receiver (20) comprising:
a first step of detecting a reception state of the selected broadcast wave signal (S16, S21, S31) by acquiring an electric filed intensity of a received signal or/and a bit error rate (BER);
a second step of loading, once the reception state falls below a given level, a plurality of fast information blocks FIBs and performing the CRC calculation on each FIB (S22, S32);
a third step of controlling the display means (8) to maintain currently displayed label information, when the calculation results indicate that the CRC values do not successively match at least three times; and
a fourth step of controlling the display means (8) to update displayed label information based on label information included in the fast information block FIB whose CRC values match last, when the calculation results indicate that the CRC values successively match at least three times.

5. The label information display method of the digital audio broadcasting receiver (20) according to Claim 4, wherein maintaining the currently displayed label information includes graying out part displaying the label information (S18, S24, S36).

6. The label information display method of the digital audio broadcasting receiver (20) according to any one of Claims 4 or 5,
wherein the digital broadcasting includes digital audio broadcasting, and wherein fast information block FIB is included in a fast information channel of a digital audio broadcasting signal.

## Patentansprüche

1. Ein Digital-Audiorundfunkempfänger (20) aufweisend:
Anzeigemittel (8);
einen Empfänger (2), um gemäß einer Anweisung ein Rundfunkwellensignal einer Rundfunkstation auszuwählen, wobei das Rundfunkwellensignal aus einer übertragenen digitalen Rundfunkradiowelle ausgewählt wird, in die mehrere Funkprogramme gebündelt sind; und
Steuermittel (5) eingerichtet zum:
Detektieren eines Empfangszustandes des ausgewählten Rundfunkwellensignals durch Erhalten einer elektrischen Feldstärke eines empfangenen Signals und/oder einer Bitfehlerrate BER; und
Durchführen von CRC-Berechnungen auf einem Schnellinformationsblock FIB, der in dem ausgewählten Rundfunkwellensignal enthalten ist, zum Ansteuern des Anzeigemittels (8) basierend auf einem Vergleich der Berechnungsresultate mit CRC-Daten, die in dem Schnellinformationsblock FIB enthalten sind, und, wenn der Empfangszustand des ausgewählten Rundfunkwellensignals unter ein vorgegebenes Niveau fällt:
Laden mehrerer Schnellinformationsblöcke FIB und Durchführen der CRC-Berechnung auf jedem FIB;
Ansteuern des Anzeigemittels (8) derart, dass die derzeit angezeigte Kennzeichnungsinformation erhalten bleibt, wenn die Berechnungsergebnisse anzeigen, dass die CRC-Werte nicht wenigstens dreimal hintereinander übereinstimmen; und
Ansteuern des Anzeigemittels (8) derart, dass die angezeigte Kennzeichnungsinformation basierend auf der Kennzeichnungsinformation des letzten Schnellinformationsblocks FIB, dessen CRC-Werte übereinstimmen, aktualisiert wird, wenn die Berechnungsergebnisse anzeigen, dass die CRC-Werte wenigstens dreimal hintereinander übereinstimmen.

2. Der Digital-Audiorundfunkempfänger (20) nach Anspruch 1, wobei das Steuermittel (5) eingerichtet ist, das Anzeigemittel (8) so anzusteuern, dass die aktuell angezeigte Kennzeichnungsinformation erhalten bleibt, wobei der Teil, der die Kennzeichnungsinformation anzeigt, ausgeblendet wird.

3. Der Digital-Audiorundfunkempfänger (20) nach einem der Ansprüche 1 oder 2,
wobei der digitale Rundfunk digitalen Audiorundfunk umfasst, und wobei der Schnellinformationsblock FIB in einem Schnellinformationskanal des digitalen Audiorundfunksignals enthalten ist.

4. Ein Informationsanzeigeverfahren, dass von einem Digital-Audiorundfunkempfänger (20) durchgeführt wird, der eine Funktion zum Durchführen von CRC-Berechnungen auf einem Schnellinformationsblock FIB, der in einem Rundfunkwellensignal enthalten ist, und zum Ansteuern eines Anzeigemittels (8) basierend auf einem Vergleich der Berechnungsergebnisse mit CRC-Daten, die in dem Schnellinformationsblock FIB enthalten sind, hat, wobei das Rundfunkwellensignal gemäß einer Anweisung aus einer übertragenen Digitalrundfunkradiowelle ausgewählt wird, wobei mehrere Radioprogramme in der Digitalrundfunkradiowelle gebündelt sind,
wobei das Informationsanzeigeverfahren des Digital-Audiorundfunkempfängers (20) umfasst:
einen ersten Schritt des Detektierens eines Empfangszustandes des ausgewählten Rundfunkwellensignals (S16, S21, S31) durch Erhalten einer elektrischen Feldstärke eines empfangenen Signals und/oder einer Bitfehlerrate BER;
einen zweiten Schritt des Ladens mehrerer Schnellinformationsblöcke FIBs und Durchführen der CRC-Berechnung auf jedem FIB (S22, S32), sobald der Empfangszustand unter ein vorgegebenes Niveau fällt;
einen dritten Schritt des Ansteuerns des Anzeigemittels (8), die derzeit angezeigte Kennzeichnungsinformation beizubehalten, wenn die Berechnungsergebnisse anzeigen, dass die CRC-Werte nicht wenigstens dreimal hintereinander übereinstimmen; und
einen vierten Schritten des Ansteuerns des Anzeigemittels, die angezeigte Kennzeichnungsinformation auf Basis der Kennzeichnungsinformation, die in dem Schnellinformationsblock FIB enthalten ist, dessen CRC-Werte zuletzt übereingestimmt haben, zu aktualisieren, wenn die Berechnungsergebnisse anzeigen, dass die CRC-Werte wenigstens dreimal hintereinander übereinstimmen.

5. Das Informationsanzeigeverfahren des Digital-Audiorundfunkempfängers (20) nach Anspruch 4, wobei das Beibehalten der derzeit angezeigten Kennzeichnungsinformation einschließt, einen Teil der angezeigten Kennzeichnungsinformation (S18, S24, S36) auszublenden.

6. Das Informationsanzeigeverfahren des Digital-Audiorundfunkempfängers (20) nach einem der Ansprüche 4 oder 5,
wobei der digitale Rundfunk digitalen Audiorundfunk umfasst, und
wobei der Schnellinformationsblock FIB in einem Schnellinformationskanal eines digitalen Audiorundfunksignals enthalten ist.

## Revendications

1. Récepteur (20) pour diffusion audio numérique, comportant :
un moyen d'affichage (8)
un syntoniseur (2) pour sélectionner un signal d'onde de diffusion d'une station de diffusion conformément à une instruction, le signal d'onde de diffusion étant sélectionné d'après une onde radio de diffusion numérique émise dans laquelle est multiplexée une pluralité d'émissions diffusées ; et
un moyen de commande (5) conçu pour :
détecter un état de réception de signal d'onde de diffusion sélectionné en acquérant une intensité de champ électrique d'un signal reçu et/ou un taux d'erreur sur les bits TEB ; et pour
effectuer des calculs de CRC sur un bloc d'information rapide BIR inclus dans le signal d'onde de diffusion sélectionné, pour commander le moyen d'affichage (8) d'après une comparaison des résultats des calculs avec les données de CRC incluses dans le bloc d'information rapide BIR et, lorsque l'état de réception du signal d'onde de diffusion sélectionné descend sous un niveau donné :
charger une pluralité de blocs d'information rapides BIR et effectuer le calcul de CRC sur chaque BIR ;
commander le moyen d'affichage (8) afin que les informations d'étiquetage affichées au même instant soient conservées, lorsque les résultats des calculs indiquent au moins trois fois de suite que les valeurs de CRC ne coïncident pas ; et
commander le moyen d'affichage (8) afin que les informations de labels affichées soient actualisées d'après les informations de labels incluses dans le bloc d'information rapide BIR dont les valeurs de CRC coïncident le plus récemment, lorsque les résultats des calculs indiquent au moins trois fois de suite que les valeurs de CRC coïncident.

2. Récepteur (20) pour diffusion audio numérique selon la revendication 1, dans lequel le moyen de commande (5) est conçu pour commander le moyen d'affichage (8) de façon que les informations de labels affichées au même instant soient conservées, la partie affichant les informations de labels étant présentée sur fond gris.

3. Récepteur (20) pour diffusion audio numérique selon l'une quelconque des revendications 1 et 2,
dans lequel la diffusion numérique comprend une diffusion audio numérique, et
dans lequel le bloc d'information rapide BIR est inclus dans un canal d'information rapide d'un signal de diffusion audio numérique.

4. Procédé d'affichage d'informations de labels mis en oeuvre par un récepteur (20) pour diffusion audio numérique dont une fonction consiste à effectuer des calculs de CRC sur un bloc d'information rapide BIR inclus dans un signal d'onde de diffusion et à commander un moyen d'affichage (8) d'après une comparaison des résultats des calculs avec les données de CRC incluses dans le bloc d'information rapide BIR, le signal d'onde de diffusion étant sélectionné d'après une onde radio de diffusion numérique émise conformément à une instruction, une pluralité d'émissions diffusées étant multiplexée dans l'onde radio de diffusion numérique,
le procédé d'affichage d'informations de labels du récepteur (20) pour diffusion audio numérique comportant :
une première étape de détection d'un état de réception du signal d'onde de diffusion sélectionné (S16, S21, S31) en acquérant une intensité de champ électrique d'un signal reçu et/ou un taux d'erreur sur les bits (TEB) :
une deuxième étape de chargement, une fois que l'état de réception descend sous un niveau donné, de blocs d'informations rapides BIR et d'exécution du calcul de CRC sur chaque BIR (S22, S32) ;
une troisième étape de commande du moyen d'affichage (8) pour conserver les informations de labels affichées au même instant, quand les résultats des calculs indiquent au moins trois fois de suite que les valeurs de CRC ne coïncident pas ; et
une quatrième étape de commande du moyen d'affichage (8) pour actualiser les informations de labels affichées d'après les informations de labels incluses dans le bloc d'information rapide BIR dont les valeurs de CRC coïncident le plus récemment, lorsque les résultats des calculs indiquent au moins trois fois de suite que les valeurs de CRC coïncident.

5. Procédé d'affichage d'informations de labels du récepteur (20) pour diffusion audio numérique selon la revendication 4, dans lequel la conservation des informations de labels affichées au même instant comprend une présentation du fond gris de la partie des informations de labels affichées (S18, S24, S36).

6. Procédé d'affichage d'informations de labels du récepteur (20) pour diffusion audio numérique selon l'une quelconque des revendications 4 et 5,
dans lequel la diffusion numérique comprend une diffusion audio numérique, et
dans lequel le bloc d'information rapide BIR est inclus dans un canal d'information rapide d'un signal de diffusion audio numérique.
